(19) Europäisches Patentamt

European Patent Office

Office européen des brevets

(11) EP 4 482 037 A1

(12) **EUROPEAN PATENT APPLICATION**

(43) Date of publication:
**25.12.2024  Bulletin 2024/52**

(21) Application number: **23180022.8**

(22) Date of filing: **19.06.2023**

(51) International Patent Classification (IPC):
**H03M 1/50** $^{(2006.01)}$        **G01J 1/46** $^{(2006.01)}$

(52) Cooperative Patent Classification (CPC):
**H03M 1/50; G01J 1/46**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **trinamiX GmbH**
**67063 Ludwigshafen am Rhein (DE)**

(72) Inventor: **OSTERMANN, Till-Jonas**
**67063 Ludwigshafen am Rhein (DE)**

(74) Representative: **Altmann Stößel Dick**
**Patentanwälte PartG mbB**
**Theodor-Heuss-Anlage 2**
**68165 Mannheim (DE)**

(54) **READOUT-CIRCUIT CONFIGURED FOR CONVERTING AN ANALOG SENSOR CURRENT INTO A DIGITAL OUTPUT COUNT**

(57)     A readout-circuit (110) configured for converting an analog sensor current (112) into a digital output count (114) is disclosed. The readout-circuit (110) comprises
- at least one integrate-and-fire (IAF)-circuit (116) configured for converting the analog sensor current (112) into a first digital output count (118);
- at least one system clock (120), the system clock (120) comprising at least one digital counter (148) configured for counting predetermined time intervals;
- at least one interface circuit (149) for receiving at least one conversion start signal (154) and at least one conversion end signal (156), wherein the interface circuit (149) is configured for triggering the IAF-circuit (116) to convert the analog sensor current (112) into the first digital output count (118) upon receiving the conversion start signal (154), wherein the IAF-circuit (116) is configured for triggering a start of the digital counter (148), wherein the digital counter (148) is configured for being terminated by the interface circuit (149) upon receiving the conversion end signal (156); and
- at least one residual conversion circuit (122) configured for converting a residual analog sensor current (124) after a final IAF cycle into a second digital output count (126), wherein the residual conversion circuit (122) is configured, by using the system clock (120), for determining a residual time (162) elapsed between the final IAF cycle and the receiving of the conversion end signal (156), wherein the residual conversion circuit (122) is configured for generating the second digital output count (126) based on a ratio of the residual time (162) and a time for one IAF cycle (160).

FIG.1

EP 4 482 037 A1

**Description**

Technical Field

The present invention relates to a readout-circuit configured for converting an analog sensor current into a digital output count, to a sensor comprising the readout-circuit and to a method for converting an analog sensor current into a digital output count. The invention further relates to a computer-readable storage medium and to a computer program for performing the method. The readout-circuit may, as an example, be used for reading out photodetectors, such as photodetectors used in a spectrometer. More specifically, the readout-circuit may be used for determining a digital output count of photoconductors, such as lead sulfide photoconductors or photodiodes, such as Si, InGaAs or SiGe. However, the readout-circuit may also be used for readout of any other sensors generating an analog sensor current.

Background art

Many sensors, such as sensors comprising one or more photodetectors, for example sensors of a spectrometer device comprising one or more photodetectors, which, upon illumination with light generate a photocurrent or a photocharge, are known which generate an analog sensor current and which has to be readout for determining the sensor's readings. For example, in spectrometer devices, application-specific integrated circuits may be used, which use a capacitor counter, also known as "integrate-and-fire" (IAF)- counter to determine a raw current signal and which can be digitalized using analog-to digital converters (ADC). A residual charge of the capacitor may be put in a slope converter which creates a digital value proportional to the residual charge.
A. Nascetti describes in "Fractional charge packet counting with constant relative resolution", International Journal of Circuit Theory and Applications, Int. J. Circ. Theor. Appl. 2012; 40:175-187, a charge-to-digital converter concept suitable for pixel-level charge sensitive amplifiers. The circuit implements a technique referred to as "fractional charge packet counting", which ensures large dynamic range operation using constant integration time. By means of a particular circuit arrangement a constant number of significant bits is provided as output, thus ensuring a constant relative resolution over the entire dynamic range.
Despite the advantages achieved in the prior art, various technical challenges still remain. Specifically, many readout-circuit may, under certain conditions, such as large currents and/or wrong default parameters, show reading errors with regard to the ADC reading. Further, a charge-to-digital converter as described by A. Nascetti may provide a determination of the residual sensor charge which uses rather complex and error-prone circuits.

Problem to be solved

It is therefore desirable to provide devices and methods which at least partially address above-mentioned technical challenges. Specifically, a readout-circuit configured for converting an analog sensor current into a digital output count, a sensor comprising the readout-circuit and a method for converting an analog sensor current into a digital output count shall be proposed which allow a simple, stable and precise readout of analog sensor currents.

Summary

This problem is addressed by a readout-circuit configured for converting an analog sensor current into a digital output count, by a sensor comprising the readout-circuit, by a method for converting an analog sensor current into a digital output count and by a computer program and a computer-readable storage medium for performing the method with the features of the independent claims. Advantageous embodiments which might be realized in an isolated fashion or in any arbitrary combinations are listed in the dependent claims as well as throughout the specification.
In a first aspect of the present invention, a readout-circuit configured for converting an analog sensor current into a digital output count is disclosed.
The term "readout" as used herein is a broad term and is to be given its ordinary and customary meaning to a person of ordinary skill in the art and is not to be limited to a special or customized meaning. The term specifically may refer, without limitation, to an action or process of quantifying and/or processing at least one physical property and/or a change in at least one physical property detected by at least one device, specifically by at least one measurement device such as at least one sensor. The measurement device may specifically comprise at least one photodetector. The photodetector may specifically comprise at least one light-sensitive region. The readout may comprise an individual readout of one device such as of one sensor. Additionally or alternatively, the readout may comprise a readout of a group of devices such as a group of sensors.
The term "readout-circuit" as used herein is a broad term and is to be given its ordinary and customary meaning to a person of ordinary skill in the art and is not to be limited to a special or customized meaning. The term specifically may refer, without limitation, to an electric circuit configured for quantifying and/or processing at least one physical property and/or a change in at least one physical property detected by at least one measurement device, such as a sensor. The readout-circuit may be configured for reading out at least one sensor. Specifically, the readout- circuit may be configured for reading out at least one photodetector or at least one sensor of the photodetector. The readout-circuit may be or may comprise at least one integrated circuit. The readout-circuit may be or may comprise at least one readout integrated circuit (ROIC).

The term "analog" as used herein is a broad term and is to be given its ordinary and customary meaning to a person of ordinary skill in the art and is not to be limited to a special or customized meaning. The term specifically may refer, without limitation, to a continuous representation in time of a physical quantity. Specifically, the term "analog" may be used in the context of electrical signals. An analog electrical signal may use at least one property of an electrical signal to represent at least one item of information on the physical quantity. For example, at least one of a voltage, a current or a frequency of the electrical signal may be used to represent the item of information on the physical quantity. Consequently, the term "analog sensor current" as used herein is a broad term and is to be given its ordinary and customary meaning to a person of ordinary skill in the art and is not to be limited to a special or customized meaning. The term specifically may refer, without limitation, to a continuous representation in time of a sensor current. For example, the analog sensor current may continuously vary over time by building up, e.g. due to an illumination of a light-sensitive region of the photodetector. Additionally or alternatively, the analog sensor current may for example continuously vary over time by dissipating, e.g. due to being transferred to further electrical components.

The term "digital" as used herein is a broad term and is to be given its ordinary and customary meaning to a person of ordinary skill in the art and is not to be limited to a special or customized meaning. The term specifically may refer, without limitation, to a finite or at least countable set of quantized or discrete signal values. Consequently, the term "digital output count" as used herein is a broad term and is to be given its ordinary and customary meaning to a person of ordinary skill in the art and is not to be limited to a special or customized meaning. The term specifically may refer, without limitation, to a finite or at least countable set of quantized or discrete counts or censuses given out by the readout-circuit. Specifically, the digital output count may be a count or a census using at least one of natural numbers, whole numbers and integers. As an example, the digital output count may start at 0 and increment by 1 for each event inducing a count, e.g. an illumination of a light-sensitive region of the photodetector with a certain intensity. The digital output count may be given out in a Boolean domain, such as by using binary digits also referred to as bits. Other options may also be feasible. The digital output count may be given out to at least one processor for further processing, e.g. for evaluating at least one sensor signal for generating measurement data displayable to a user.

The terms "first" and "second" as used herein, specifically for the first and second digital output count, are used for nomenclature only, without indicating an order or ranking. Thus, it may be possible to have one or more first digital output counts and/or one or more second digital output counts. The first and second digital output may be of the same type and/or may be of different type.

The term "converting" as used herein is a broad term and is to be given its ordinary and customary meaning to a person of ordinary skill in the art and is not to be limited to a special or customized meaning. The term specifically may refer, without limitation, to a process of transforming at least one first signal into at least one second signal. Specifically, with the transformation of the first signal into the second signal, at least one property of the first signal may be changed or varied resulting in obtaining the second signal. The converting may comprise transforming at least one first analog signal, such as at least one first analog electrical signal, into at least one second digital signal, such as at least one second digital signal representing information on the first analog signal. For example, the converting may comprise transforming at least one analog sensor current into at least one digital output count representing information on the analog sensor current.

The readout-circuit comprises:

- at least one integrate-and-fire (IAF)-circuit configured for converting the analog sensor current into a first digital output count;
- at least one system clock, the system clock comprising at least one digital counter configured for counting predetermined time intervals;
- at least one interface circuit for receiving at least one conversion start signal and at least one conversion end signal, wherein the interface circuit is configured for triggering the IAF-circuit to convert the analog sensor current into the first digital output count upon receiving the conversion start signal, wherein the IAF-circuit is configured for triggering a start of the digital counter, wherein the digital counter is configured for being terminated by the interface circuit upon receiving the conversion end signal; and
- at least one residual conversion circuit configured for converting a residual analog sensor current after a final IAF cycle into a second digital output count, wherein the residual conversion circuit is configured, by using the system clock, for determining a residual time elapsed between the final IAF cycle and the receiving of the conversion end signal, wherein the residual conversion circuit is configured for generating the second digital output count based on a ratio of the residual time and a time for one IAF cycle.

The term "integrate-and-fire-circuit", also denoted as "IAF-circuit", as used herein is a broad term and is to be given its ordinary and customary meaning to a person of ordinary skill in the art and is not to be limited to a special or customized meaning. The term specifically may refer, without limitation, to an electric circuit configured for integrating an incoming analog sensor current, e.g. by using an integrator, and firing an event signal, e.g. by using a comparator, when an output voltage reaches a predefined quantization threshold. The event can be used to reset the integrator in order to start again with the integration of the incoming analog sensor current. The incoming analog sensor current e.g. may be based on at least one capacitive trans-impedance amplifier (CTIA). The IAF-circuit may specifically be configured for converting the incoming analog sensor current into a digital output count, also referred to as "first digital output count". Different types of IAF-circuits are generally known to the skilled person, e.g. from the publication Dei, Michele, et al. "Highly linear integrate-and-fire modulators with soft reset for low-power high-speed imagers", 2017 IEEE International Symposium on Circuits and Systems (ISCAS), IEEE, 2017, which is included here in its entirety. Without limitation, specific embodiments of the IAF-circuit will also be outlined below in further detail.

The IAF circuit may comprise at least one integrator. The term "integrator" as used herein is a broad term and is to be given its ordinary and customary meaning to a person of ordinary skill in the art and is not to be limited to a special or customized meaning. The term specifically may refer, without limitation, to an electric circuit configured for integrating at least one input signal, specifically over time. In other words, the integrator may be configured for accumulating the input signal over time. Specifically, the integrator may be a current integrator. The integrator may be configured for measuring the analog sensor current. The integrator may comprise at least one of an operational amplifier and a capacitor. The operational amplifier may be an inverted operational amplifier. The operational amplifier and the capacitor may be connected in parallel. The IAF-circuit may specifically comprise at least one capacitor, wherein the IAF-circuit may be configured for employing a linear nature of a charge-to-voltage conversion using the capacitor. The integrator may comprise at least one mixed signal circuit, specifically for resetting the integrator. The integrator may comprise at least on charge amplifier. Further options are feasible and are generally known to the skilled person.

An input of the operational amplifier may be held to a known voltage $V_{ref}$. The integrator may be configured for resetting an output of the operational amplifier to $V_{ref}$ after each saturation event. The integrator may be configured for integrating the output of the operational amplifier between the reference voltage $V_{ref}$ and a comparator voltage $V_{comp}$ for determining an integration voltage Vint.

The term "integration voltage", also referred to as $V_{int}$, as used herein is a broad term and is to be given its ordinary and customary meaning to a person of ordinary skill in the art and is not to be limited to a special or customized meaning. The term specifically may refer, without limitation, to a voltage output generated by the integrator, specifically by the operational amplifier of the integrator.

The term "reference voltage", also referred to as $V_{ref}$, as used herein is a broad term and is to be given its ordinary and customary meaning to a person of ordinary skill in the art and is not to be limited to a special or customized meaning. The term specifically may refer, without limitation, to a predefined voltage serving as a reference, specifically for the integrator. The reference voltage may specifically be applied to the operational amplifier of the integrator, specifically to a first input of the typically two inputs of the operational amplifier. The analog sensor current may specifically be fed into a second input of the operational amplifier. An output of the operational amplifier may further be fed back into the second input, specifically via the capacitor.

The term "comparator voltage", also referred to as $V_{comp}$, as used herein is a broad term and is to be given its ordinary and customary meaning to a person of ordinary skill in the art and is not to be limited to a special or customized meaning. The term specifically may refer, without limitation, to a predefined voltage serving as a reference or threshold, specifically for the comparator.

The IAF circuit may further comprise at least one comparator, specifically at least one Schmitt-trigger, configured for determining a saturation event. The term "comparator" as used herein is a broad term and is to be given its ordinary and customary meaning to a person of ordinary skill in the art and is not to be limited to a special or customized meaning. The term specifically may refer, without limitation, to an electric circuit configured for comparing at least two input signals, specifically voltages. The comparator may be configured for generating at least one output signal, specifically a digital output signal, indicating a result of the comparison, e.g. which input signal is larger. As an example, the comparator may generate as an output "HIGH" or "1" in the case that a first input voltage is equal or higher than a second input voltage and "LOW" or "0" in the case that the first input voltage is lower than the second input voltage. The output signal may be generated continuously over time, specifically for varying input signals. The comparator may be configured for comparing $V_{int}$ with $V_{comp}$. Specifically, the comparator may be configured for detecting when $V_{int}$ is equal to $V_{comp}$. The comparator may be configured for generating an event signal, also denoted as event, each time $V_{int}$ crosses $V_{comp}$.

The comparator may be and/or may comprise at least one Schmitt-trigger. The Schmitt-trigger may be an inverting or a non-inverting Schmitt-trigger. The term "Schmitt-trigger" as used herein is a broad term and is to be given its ordinary and customary meaning to a person of ordinary skill in the art and is not to be limited to a special or customized meaning. The term specifically may refer, without limitation, to a comparator circuit in which switch-on and switch-off thresholds are offset from each other by a switching hysteresis. The Schmitt-trigger may be configured for comparing an input voltage, specifically a voltage varying over time, with two threshold voltages, an upper threshold voltage and a lower threshold voltage. Specifically, the Schmitt-trigger may be configured for giving out HIGH or 1 in case the input voltage is higher than the upper threshold voltage and LOW or 0 in case the input voltages is lower than the lower threshold voltage, wherein the Schmitt-trigger may further be configured for maintaining a preceding output between the upper threshold voltage and the lower threshold voltage. In other words, as long as the input voltage does not exceed one of the two threshold voltage, an output of the Schmitt-trigger may not be altered. However, other options for a comparator are also feasible.

The output of the operational amplifier may begin at the known voltage $V_{ref}$ upon reset. The output of the operational amplifier may decrease as the charge from the sensor is integrated. The output of the operational amplifier may be connected to a comparator V- input. When the output of the operational amplifier/comparator V- input drops below a comparator V+ terminal, a comparator output may toggle HIGH. The toggling of the comparator may trigger a reset circuit that pulls the output of the operational amplifier back to the initial voltage state $V_{ref}$ such that the integration cycle can begin again. The comparator output change to HIGH may be the saturation event that triggers resetting of the integrator. The comparator output change may, in particular simultaneously, increase a counter value by 1. In this manner, the integration cycles may be counted. Each finished integration cycle may increment the first digital output count by 1.

The term "saturation event" as used herein is a broad term and is to be given its ordinary and customary meaning to a person of ordinary skill in the art and is not to be limited to a special or customized meaning. The term specifically may refer, without limitation, to an occurrence of a saturation or a satiation of an electric component, specifically of the integrator, more specifically of the capacitor of the integrator.

The integration capacitor value may affect the frequency of saturation events in the system. A smaller capacitor may thus produce a higher number of saturation events per second compared to a larger capacitor. Thus, for the same charge, a smaller capacitor may count more events than a larger capacitor. A capacitance of the capacitor may be defined by the size of the capacitor, e.g. by a ratio of an area of capacitor plates divided by a distance between the capacitor plates. The occurrence of a saturation event may refer to a finished integration cycle of the integrator.

The IAF circuit may further comprise at least one counter configured for determining the first digital output count by counting the saturation events. The term "counter" as used herein is a broad term and is to be given its ordinary and customary meaning to a person of ordinary skill in the art and is not to be limited to a special or customized meaning. The term specifically may refer, without limitation, to an electric circuit configured for counting events. The counter may be configured for storing a number of times a particular event has occurred. Specifically, for each determined saturation event, the counter may be incremented by 1. The counter may comprise at least one output. The counter may be configured for giving out the count or, in other words, the number of times a particular event has occurred, specifically in a binary number system. Other options are feasible. The counter may comprise at least one input. An input of the counter may be connected to the above-described comparator. A further input of the counter may be connected to a clock, specifically to the system clock of the read-out circuit. The counter may comprise a plurality of flip-flops connected in a cascade. The counter may be a synchronous counter. The flip-flops may be simultaneously triggered by the clock. However, the counter may also be an asynchronous counter. Other options are feasible and are generally known to the skilled person. The first digital output count, also denoted as IAF digital output, may represent a whole number of saturation events for a given input charge. The first digital output count may be proportional to a whole number of integration cycles. Specifically, the counter of the IAF-circuit may be a most significant bits (MSB) counter. The MSB counter may be configured for determining the most significant bits of an output of the readout-circuit. The readout-circuit may comprise at least one switch for resetting the MSB counter. For example, the MSB counter may comprise a reset pin to reset the count back to 0.

The IAF circuit may further comprise at least one mixed signal circuit configured for resetting $V_{int}$ to $V_{ref}$ after each saturation event. The mixed signal circuit may be connected in parallel to the integrator or the capacitor of the integrator generating a short circuit when closed. The mixed signal circuit may be an electrical switch or an electromechanical switch. Specifically, the mixed signal circuit may comprise at least one transmission gate. The reset of the output of the operational amplifier may be a critical component of the IAF. The IAF-circuit may be configured to ensure that the reset happens quickly and automatically after each saturation event. The analog voltage needs to be consistently returned to $V_{ref}$ after every event.

As outlined above, the comparator may be configured for determining a saturation event when $V_{int}$ reaches $V_{comp}$ and for firing an event signal. However, at the final integration cycle, also denoted as "final IAF cycle", of integrating the incoming analog sensor current, there may be a remainder which, because the integrated voltage does not reach the quantization threshold Vcomp ($V_{int} > V_{comp}$), cannot trigger firing an event and, thus, is not counted. The term "residual analog sensor current" as used herein is a broad term and is to be given its ordinary and customary meaning to a person of ordinary skill in the art and is not to be limited to a special or customized meaning. The term specifically may refer, without limitation, to a remainder or a rest or a residual which is left after a complete processing of the analog sensor current by the IAF-circuit, specifically at the end of the final finished integration cycle. The residual analog sensor current may be one or more of characterized, described or quantified by using at least one analog voltage. The residual analog sensor current may refer to a remainder of a final unfinished integration cycle. The residual analog sensor current may be a leftover analog sensor current after the final IAF cycle that has not triggered a saturation event. The residual analog sensor current may be a non-digitizable remainder of the analog sensor current which is not detectable and/or not quantifiable by the IAF-circuit. An unfinished integration cycle may specifically not be quantifiable by the IAF-circuit and, thus, not be digitizable by the IAF-circuit, whereas a finished integration cycle may be digitizable by incrementing a counter of the IAF-circuit. As an example, the analog sensor current may not be high enough for generating a finished integration cycle in the IAF-circuit, such that the analog sensor current as a whole may not be digitizable. Thus, specifically for small analog sensor currents, the IAF-circuit may not be sufficient.

The read-out circuit, as outlined above, comprises the at least one system clock comprising the at least one digital counter.

The term "system clock" as used herein is a broad term and is to be given its ordinary and customary meaning to a person of ordinary skill in the art and is not to be limited to a special or customized meaning. The term specifically may refer, without limitation, to an electric device configured for generating at least one clock signal, specifically at least one clock signal used for counting time intervals. The system clock may be a clock generator, specifically an electronic oscillator. For example, the system clock may be a resistor-capacitor (RC) clock oscillator, a quartz oscillator or a Bulk-Acoustic-Wave (BAW) oscillator. The system clock may be configured for generating the clock signal comprising an electronic logic signal, such as a voltage or a current, which specifically oscillates between a high state and a low state. The clock signal may be a square wave signal or a sine wave signal. The clock signal may have a constant clock frequency. The system clock may be a 8 MHz system clock, specifically a 16 MHz system clock, more specifically a 32 MHz system clock. A resolution of the readout-circuit may improve with higher clock frequencies even though higher clock frequencies enhance electric energy consumption. The system clock may comprise at least one clock network, such as a metal grid, for distributing the clock signal in the readout-circuit, specifically to one or more of the IAF-circuit, the digital counter, the interface circuit and/or the residual conversion circuit. The clock signal may be used for determining time intervals. Specifically, the clock signal may determine time intervals elapsing between a start signal and an end signal. By counting time intervals between a start signal and an end signal, it may be possible to determine a time, e.g. a time span, elapsed between the start signal and the end signal. For example, counted time intervals between the final IAF cycle and the receiving of the conversion end signal may be used for converting the residual analog sensor current after the final IAF cycle into the second digital output count.

As outlined above, the system clock comprises the at least one digital counter configured for counting predetermined time intervals. The term "digital counter" as used herein is a broad term and is to be given its ordinary and customary meaning to a person of ordinary skill in the art and is not to be limited to a special or customized meaning. The term specifically may refer, without limitation, to a counter in above-defined sense, i.e. to an electric circuit configured for counting events, which is configured for counting a number of predetermined time intervals elapsed between start and termination. The term "predetermined time interval" may refer, without limitation, to a time interval defined by the clock frequency of the system clock. The digital counter may have at least one input configured for receiving the clock signal from the system clock. The digital counter may be configured for counting the number of predetermined time intervals elapsed between start and termination based on the clock signal from the system clock. The digital counter may further comprise at least one register for storing the counted predetermined time intervals. The digital counter may be configured for being triggered by the IAF-circuit for starting counting the predetermined time intervals. The digital counter may be configured for being terminated by the IAF-circuit at an end of the integration measurement. The start of the digital counter may be defined by an end of the final IAF cycle. The termination of the digital counter may be defined by an end of the integration measurement of the IAF-circuit. The digital counter may be configured for counting the number of predetermined time intervals between start and termination, i.e. between the end of the final IAF cycle and the end of the integration measurement of the IAF-circuit. The IAF-circuit may be configured for resetting the digital counter, specifically for resetting the digital counter after the termination of the digital counter. The digital counter may be configured for providing the counted number of predetermined time intervals to the residual conversion circuit.

The term "interface circuit" as used herein is a broad term and is to be given its ordinary and customary meaning to a person of ordinary skill in the art and is not to be limited to a special or customized meaning. The term specifically may refer, without limitation, to an electric circuit forming a boundary configured for transferring information. Specifically, the interface circuit may be configured for receiving signals, such as control signals, e.g. a control signal triggering the start of the conversion with the IAF-circuit and/or a control signal triggering an end of the conversion with the IAF-circuit. The control signals received via the interface circuit triggering a start of the conversion and an end of the conversion may be denoted as "conversion start signal" and "conversion end signal", respectively. The control signals received by the interface circuit may be analog or digital signals. The interface circuit may be configured for receiving analog or digital signals. The interface circuit may be configured for receiving the conversion start signal and/or the conversion end signal from at least one other electronic component, such as from at least one microcontroller, generating the respective signals. For example, the conversion start signal may comprise an integration clock signal changing from at least one first state, for example a "low state", to at least one second state, for example a "high state". The conversion end signal may comprise an integration clock signal changing from the at least one second state, for example a "high state", to the at least one first state, for example a "low state". The integration clock signal may, as an example, comprise a 1 kHz signal, specifically haviing a DC of e.g. 90%. The integration clock signal may be used for determining an active state of the readout-circuit, specifically of the IAF-circuit.

Further, as outlined above, the readout-circuit comprises the at least one residual conversion circuit. The term "residual conversion circuit" as used herein is a broad term and is to be given its ordinary and customary meaning to a person of ordinary skill in the art and is not to be limited to a special or customized meaning. The term specifically may refer, without limitation, to an electric circuit configured for converting the residual analog charge into a digital output count, also referred to as "second digital output count". The residual conversion circuit may specifically be configured for converting the residual analog charge into the second digital output count by using a time-based approach. The residual conversion circuit may have at least one input for receiving the counted number of predetermined time intervals from the digital counter. Based on the counted number of predetermined time intervals and taking into account the clock frequency of the system clock, the residual conversion circuit may be configured for determining the residual time. The term "residual time" as used herein is a broad term and is to be given its ordinary and customary meaning to a person of ordinary skill in the art and is not to be limited to a special or customized meaning. The term specifically may refer, without limitation, to a time interval between start and termination of the digital counter. The residual time may specifically be the time interval between the end of the final IAF cycle and the end of the integration measurement of the IAF-circuit, specifically being determined by the conversion end signal. The residual time may be indicative of the residual analog charge under the condition that the current in the IAF-circuit during one measurement cycle does not change. The residual conversion circuit may be configured for determining the residual analog sensor current based on the ratio of the residual time and the time for one IAF cycle.

The readout-circuit may be configured, specifically by using the system clock, for determining the time for one IAF cycle based on at least one of a time for the final IAF cycle or an average time of preceding IAF cycles, specifically an average time of all preceding IAF cycles.

The readout-circuit may be configured for determining a combined digital output count by combining the first digital output count and the second digital output count. The first digital output count may be proportional to an integer of IAF cycles. The readout-circuit may be configured for determining the combined digital output count according to:

$$ADC_{out} = ADC_{IAF\_Event} + ADC_{residual},$$

wherein $ADC_{out}$ denotes the combined digital output count, $ADC_{IAF\_Event}$ denotes the first digital output count and $ADC_{residual}$ denotes the second digital output count.

The readout-circuit may be configured for determining the combined digital output count according to:

$$ADC_{out} = \sum IAF_{Events} + \frac{t_{EndOfMeasurement-LastIAF}}{t_{1IAF}},$$

wherein $\Sigma IAF_{Events}$ denotes a total number of IAF cycles, $t_{EndofMeasurment-LastIAF}$ denotes the residual time and $t_{1IAF}$ denotes the time for one IAF cycle.

The readout-circuit may be an application-specific integrated circuit (ASIC) configured for readout of at least one sensor. The term "sensor" as used herein is a broad term and is to be given its ordinary and customary meaning to a person of ordinary skill in the art and is not to be limited to a special or customized meaning. The term specifically may refer, without limitation, to an arbitrary element or device configured for detecting at least one condition or for measuring at least one measurement variable. The sensor may be configured for generating the analog sensor current dependent on an illumination of a light-sensitive region of the sensor. As an example, the sensor may be a light-sensitive sensor as e.g. used in a photodetector. However, alternatively or additionally, the sensor may be or may comprise at least one resistor or at least provides an electrical signal, e.g. a load cell with strain gauge. Other options are also feasible. The sensor may be capable of generating at least one signal, such as a measurement signal, which is a qualitative or quantitative indicator of the measurement variable and/or measurement property, e.g. of an illumination of the sensor. The signal may be or comprise an electrical signal, such as a current or a charge.

The readout-circuit may be an integrated circuit (IC), also referred to as chip or microchip, or the readout-circuit may at least form a part of an IC. As the skilled person will know, an IC typically comprises at least one electric circuit assembled on a substrate, specifically a semiconductor substrate, more specifically a silicon (Si) substrate. The readout-circuit may be configured for accumulating at least one sensor current, specifically a photocurrent, wherein the accumulating of the sensor current may generate the analog sensor current. As an example, the readout-circuit may be configured for accumulating a photocurrent for each sensor of a photodetector or for groups of sensors of the photodetector. The readout-circuit may be configured for storing or at least for buffering the analog sensor current. The readout-circuit may be configured for transferring the analog sensor current to at least one output, e.g. an output of an IC, wherein the output may specifically be a digital output. The readout-circuit may be a digital readout integrated circuit (DROIC). The DROIC may use on-chip analog-to-digital conversion, specifically for digitizing at least one accumulated photocurrent. The readout-circuit may be a digital pixel readout integrated circuit (DPROIC). The DPROIC uses on-chip analog-to-digital conversion within each pixel or group of pixels, specifically for digitizing at least one accumulated photocurrent, wherein a pixel may specifically refer to a sensor of a photodetector.

The readout-circuit may specifically be a multi-channel ASIC configured for readout of a plurality of sensors. Each sensor may be configured for generating the analog sensor current dependent on an illumination of a light-sensitive region of the sensor. The sensors may be arranged in an array. The term "array" as used herein is a broad term and is to be given its ordinary and customary meaning to a person of ordinary skill in the art and is not to be limited to a special or customized meaning. The term specifically may refer, without limitation, to a spatial arrangement of elements such as sensors. The array may be a one-dimensional array, e.g. a sensor sequence along an axis, or a two-dimensional array, e.g. a sensor matrix. The array may also be a three-dimensional array. The array may be a regular array, e.g. comprising constant distances between elements. The array may be an irregular array, e.g. comprising different distances between elements. The elements within the array may be of the same type or of a different type. As an example, the array may comprise sensors which are light-sensitive for different wavelengths. Further options are feasible.

The sensor may specifically be at least one sensor configured for generating the analog sensor current dependent on an illumination of its light-sensitive region. The light-sensitive region may comprise at least one photoconductive material selected from the group consisting of lead sulfide (PbS); lead selenide (PbSe); mercury cadmium telluride (HgCdTe); cadmium sulfide (CdS); cadmium selenide (CdSe); indium antimonide (InSb); indium arsenide (InAs); indium galli-um arsenide (InGaAs); silicon (Si); Silicon Germanium (SiGe); extrinsic semiconductors, organic semiconductors.

In a further aspect of the present invention, a sensor configured for generating an analog sensor current dependent on a sensor reading is disclosed. The sensor comprises at least one readout-circuit configured for converting the analog sensor current into a digital output count according to the present invention, such as according to any one of the embodiments disclosed above and/or according to any one of the embodiments disclosed in further detail below. For definitions of terms and possible embodiment of the readout-circuit, reference is made to the description of the readout-circuit above.

The term "sensor", as outlined above, is a broad term and is to be given its ordinary and customary meaning to a person of ordinary skill in the art and is not to be limited to a special or customized meaning. The term specifically may refer, without limitation, to an arbitrary element or device configured for detecting at least one condition or for measuring at least one measurement variable. Consequently, the term "sensor reading" may refer, without limitation to the condition or the measurement variable detected or measured by the sensor. Specifically, the sensor reading may cause a response in the sensor, wherein the sensor, if the sensor reading is acquired, is configured for generating the analog sensor current. For example, the sensor reading may be an illumination of the sensor, e.g. a radiometric unit of spectral flux, such as a spectral power density.

The sensor may specifically be and/or comprise at least one photodetector comprising at least one sensor configured for generating an analog sensor current dependent on an illumination of a light-sensitive region of the sensor. The term "photodetector" as used herein is a broad term and is to be given its ordinary and customary meaning to a person of ordinary skill in the art and is not to be limited to a special or customized meaning. The term specifically may refer, without limitation, to a measurement device configured for detecting optical radiation, such as for detecting an illumination and/or a light spot generated by at least one light beam. The photodetector may be and/or may comprise a photoconductor or a photodiode. The photodetector may comprise at least one substrate. A single photodetector may be a substrate with at least one single light-sensitive region, which generates a physical response to the illumination for a given wavelength range. The photodetector comprises at least one sensor configured for generating an analog sensor current dependent on an illumination of a light-sensitive region of the sensor.

The term "illumination", also referred to as "light", as used herein is a broad term and is to be given its ordinary and customary meaning to a person of ordinary skill in the art and is not to be limited to a special or customized meaning. The term specifically may refer, without limitation, to electromagnetic radiation in one or more of the visible spectral range, the ultraviolet spectral range and the infrared spectral range. Therein, in partial accordance with standard ISO-21348, the term visible spectral range generally refers to a spectral range of 380 nm to 760 nm. The term infrared (IR) spectral range generally refers to electromagnetic radiation in the range of 760 nm to 1000 $\mu$m, wherein the range of 760 nm to 1.4 $\mu$m is usually denominated as the near infrared (NIR) spectral range, and the range from 15 $\mu$m to 1000 $\mu$m as the far infrared (FIR) spectral range. The term "ultraviolet spectral range" generally refers to electromagnetic radiation in the range of 1 nm to 380 nm, preferably in the range of 100 nm to 380 nm. The term "light" may also be denoted as "illumination". Preferably, illumination as used within the present invention is visible light, i.e. light in the visible spectral range, and/or infrared light, i.e. light in the infrared spectral range. The photodetector may specifically be a NIR photodetector configured for detecting optical radiation in the NIR spectral range.

In a further aspect of the present invention, a method for converting an analog sensor current into a digital output count is disclosed. The method comprises using at least one readout-circuit according to the present invention, such as according to any one of the embodiments disclosed above and/or according to any one of the embodiments disclosed in further detail below. For definitions of terms and possible embodiment of the readout-circuit, reference is made to the description of the readout-circuit above.

The method may comprise further method steps which are not listed. Further, one or more of the method steps may be performed once or repeatedly. Further, two or more of the method steps may be performed simultaneously or in a timely overlapping fashion.

The method comprises:

a) converting the analog sensor current into a first digital output count using the IAF-circuit, wherein the interface circuit triggers the IAF-circuit to convert the analog sensor current into the first digital output count upon receiving at least one conversion start signal, wherein the IAF-circuit further triggers a start of the digital counter; and

b) converting a residual analog sensor current after a final IAF cycle into a second digital output count using the residual conversion circuit, wherein the residual conversion circuit determines, by using the system clock, a residual time elapsed between the final IAF cycle and the receiving of at least one conversion end signal, wherein the residual conversion circuit generates the second digital output count based on a ratio of the residual time and a time for one IAF cycle, wherein the determining of the residual time comprises counting predetermined time intervals by using the digital counter and terminating the digital counter by using the interface circuit upon receiving the conversion end signal.

The method may comprise, specifically in and/or after step b), resetting the digital counter using the IAF-circuit, specifically resetting the digital counter after the termination of the digital counter.

The method may further comprise determining the time for one IAF cycle based on at least one of a time for the final IAF cycle or an average time of preceding IAF cycles, specifically an average time of all preceding IAF cycles, by using the system clock.

The method may further comprise:

c) determining a combined digital output count by combining the first digital output count and the second digital output count, wherein the first digital output count is proportional to an integer of IAF cycles.

The combined digital output count may be determined according to:

$$ADC_{out} = ADC_{IAF\_Event} + ADC_{residual},$$

wherein $ADC_{out}$ denotes the combined digital output count, $ADC_{IAF\_Event}$ denotes the first digital output count and $ADC_{residual}$ denotes the second digital output count.

Alternatively or additionally, the combined digital output count may be determined according to:

$$ADC_{out} = \sum IAF_{Events} + \frac{t_{EndOfMeasurment-LastIAF}}{t_{1IAF}},$$

wherein $\Sigma IAF_{Events}$ denotes a total number of IAF cycles, $t_{EndofMeasurment-LastIAF}$ denotes the residual time and $t_{1IAF}$ denotes the time for one IAF cycle.

The method may be at least partially computer-implemented, specifically at least one of steps b) and c). The term "computer-implemented" as used herein is a broad term and is to be given its ordinary and customary meaning to a person of ordinary skill in the art and is not to be limited to a special or customized meaning. The term specifically may refer, without limitation, to a process which is fully or partially implemented by using a data processing means, such as data processing means comprising at least one processing unit. The computer-implementation of the method, specifically of steps b) and/or c), may involve using at least one computer and/or at least one computer network. The computer and/or computer network may comprise at least one processor which is configured for performing at least one of the method steps, specifically at least one of steps b) and/or c). Preferably each of the method steps, specifically each of the method steps b) and/or c), is performed by the computer and/or computer network. The method may be performed completely automatically, specifically without user interaction.

In a further aspect of the present invention, a computer-readable storage medium, specifically a non-transient computer-readable storage medium, is disclosed, including instructions that, when executed by one or more processors, cause the one or more processors to perform the method according to any one of the preceding claims referring to a method. Specifically, the computer-readable storage medium may include instructions that, when executed by the one or more processors, cause the one or more processors to perform at least steps b) and optionally c) of the method.

As used herein, the term "computer-readable storage medium" specifically may refer to non-transitory data storage means, such as a hardware storage medium having stored thereon computer-executable instructions. The computer-readable storage medium specifically may be or may comprise a storage medium such as a random-access memory (RAM) and/or a read-only memory (ROM).

In a further aspect of the present invention, a computer program is disclosed, comprising instructions, which, when executed by one or more processors, cause the one or more processors to perform the method according to any one of the preceding claims referring to a method. Specifically, the computer program may comprise instructions that, when executed by the one or more processors, cause the one or more processors to perform at least steps b) and optionally c) of the method.

The term "processor" as used herein is a broad term and is to be given its ordinary and customary meaning to a person of ordinary skill in the art and is not to be limited to a special or customized meaning. The term specifically may refer, without limitation, to an arbitrary logic circuitry configured for performing basic operations of a computer or system, and/or, generally, to a device which is configured for performing calculations or logic operations. In particular, the processor may be configured for processing basic instructions that drive the computer or system. As an example, the processor may comprise at least one arithmetic logic unit (ALU), at least one floating-point unit (FPU), such as a math co-processor or a numeric co-processor, a plurality of registers, specifically registers configured for supplying operands to the ALU and storing results of operations, and a memory, such as an L1 and L2 cache memory. In particular, the processor may be a multi-core processor. Specifically, the processor may be or may comprise a central processing unit (CPU). Additionally or alternatively, the processor may be or may comprise a microprocessor, thus specifically the processor's elements may be contained in one single integrated circuitry (IC) chip. Additionally or alternatively, the processor may be or may comprise one or more application-specific integrated circuits (ASICs) and/or one or more field-programmable gate arrays (FPGAs) and/or one or more tensor processing unit (TPU) and/or one or more chip, such as a dedicated machine learning optimized chip, or the like. The processor specifically may be configured, such as by software programming, for performing one or more of the method steps.

In a further aspect of the present invention, a use of a readout-circuit according to the present invention, such as according to any one of the embodiments disclosed above and/or according to any one of the embodiments disclosed in further detail below, for readout of one or more of at least one PbS sensor, at least one PbSe sensor, or at least one pixelated sensor array is disclosed. The pixelated sensor array comprises a plurality of pixels, wherein each of the pixels comprises at least one PbS or PbSe sensor.

The devices and the method according to the present invention may provide a large number of advantages over known devices and methods. Specifically, under the assumption that the current of the sensor may not change during one conversion, the residual charge can be determined by building a quotient of times, according to

$$ADC_{out} = ADC_{IAF\_Event} + ADC_{residual}$$

$$ADC_{out} = \sum IAF_{Events} + \frac{t_{EndOfMeasurement-LastIAF}}{t_{1IAF}}.$$

The time for one IAF cycle, such as the time for one integrate and fire event, can either be the time for the final IAF cycle or an average time of preceding IAF cycles, specifically an average time of all preceding IAF cycles. Further, it is possible to improve the performance in a real application by using faster system clocks, e.g. using a 8MHz system clock. By implementing timers to further measure the timestamps, the resolution can be improved by using faster system clocks like e.g. a 32 MHz system clock, which would improve the resolution of the application by 2 further bits.

The devices and the method may specifically provide the advantage of a purely time-based approach for determining the residual analog charge, which allows for high repeatability. Further, the time-based approach may provide a natural resolution improvement at small current readings. However, it may be ensured that there is at least one IAF bit to work and that the current may exceed high current readings since, in this case, the resolution of the residual converter may degrade.

As used herein, the terms "have", "comprise" or "include" or any arbitrary grammatical variations thereof are used in a non-exclusive way. Thus, these terms may both refer to a situation in which, besides the feature introduced by these terms, no further features are present in the entity described in this context and to a situation in which one or more further features are present. As an example, the expressions "A has B", "A comprises B" and "A includes B" may both refer to a situation in which, besides B, no other element is present in A (i.e. a situation in which A solely and exclusively consists of B) and to a situation in which, besides B, one or more further elements are present in entity A, such as element C, elements C and D or even further elements.

Further, it shall be noted that the terms "at least one", "one or more" or similar expressions indicating that a feature or element may be present once or more than once typically are used only once when introducing the respective feature or element. In most cases, when referring to the respective feature or element, the expressions "at least one" or "one or more" are not repeated, notwithstanding the fact that the respective feature or element may be present once or more than once.

Further, as used herein, the terms "preferably", "more preferably", "particularly", "more particularly", "specifically", "more specifically" or similar terms are used in conjunction with optional features, without restricting alternative possibilities. Thus, features introduced by these terms are optional features and are not intended to restrict the scope of the claims in any way. The invention may, as the skilled person will recognize, be performed by using alternative features. Similarly, features introduced by "in an embodiment of the invention" or similar expressions are intended to be optional features, without any restriction regarding alternative embodiments of the invention, without any restrictions regarding the scope of the invention and without any restriction regarding the possibility of combining the features introduced in such way with other optional or non-optional features of the invention.

Summarizing and without excluding further possible embodiments, the following embodiments may be envisaged:

Embodiment 1: A readout-circuit configured for converting an analog sensor current into a digital output count, comprising

- at least one integrate-and-fire (IAF)-circuit configured for converting the analog sensor current into a first digital output count;
- at least one system clock, the system clock comprising at least one digital counter configured for counting predetermined time intervals;
- at least one interface circuit for receiving at least one conversion start signal and at least one conversion end signal, wherein the interface circuit is configured for triggering the IAF-circuit to convert the analog sensor current into the first digital output count upon receiving the conversion start signal, wherein the IAF-circuit is configured for triggering a start of the digital counter, wherein the digital counter is configured for being terminated by the interface circuit upon receiving the conversion end signal; and
- at least one residual conversion circuit configured for converting a residual analog sensor current after a final IAF cycle into a second digital output count, wherein the residual conversion circuit is configured, by using the system clock, for determining a residual time elapsed between the final IAF cycle and the receiving of the conversion end signal, wherein the residual conversion circuit is configured for generating the second digital output count based on a ratio of the residual time and a time for one IAF cycle.

Embodiment 2: The readout-circuit according to the preceding embodiment, wherein the IAF-circuit is configured for resetting the digital counter, specifically for resetting the digital counter after the termination of the digital counter.

Embodiment 3: The readout-circuit according to any one of the preceding embodiments, wherein the readout-circuit is configured, specifically by using the system clock, for determining the time for one IAF cycle based on at least one of a time for the final IAF cycle or an average time of preceding IAF cycles, specifically an average time of all preceding IAF cycles.

Embodiment 4: The readout-circuit according to any one of the preceding embodiments, wherein the readout-circuit is configured for determining a combined digital output count by combining the first digital output count and the second digital output count, wherein the first digital output count is proportional to an integer of IAF cycles.

Embodiment 5: The readout-circuit according to the preceding embodiment, wherein the readout-circuit is configured for determining the combined digital output count according to:

$$ADC_{out} = ADC_{IAF\_Event} + ADC_{residual},$$

wherein $ADC_{out}$ denotes the combined digital output count, $ADC_{IAF\_Event}$ denotes the first digital output count and $ADC_{residual}$ denotes the second digital output count.

Embodiment 6: The readout-circuit according to any one of the two preceding embodiments, wherein the readout-circuit is configured for determining the combined digital output count according to:

$$ADC_{out} = \sum IAF_{Events} + \frac{t_{EndOfMeasurement-LastIAF}}{t_{1IAF}},$$

wherein $\sum IAF_{Events}$ denotes a total number of IAF cycles, $t_{EndOfMeasurment-LastIAF}$ denotes the residual time and $t_{1IAF}$ denotes the time for one IAF cycle.

Embodiment 7: The readout-circuit according to any one of the preceding embodiments, wherein the system clock is a 8 MHz system clock, specifically a 16 MHz system clock, more specifically a 32 MHz system clock.

Embodiment 8: The readout-circuit according to any one of the preceding embodiments, wherein the system clock is a resistor-capacitor (RC) clock oscillator, a quartz oscillator or a Bulk-Acoustic-Wave (BAW) oscillator.

Embodiment 9: The readout-circuit according to any one of the preceding embodiments, wherein the readout-circuit is an application-specific integrated circuit (ASIC) configured for readout of at least one sensor such as at least one sensor configured for generating the analog sensor current dependent on an illumination of a light-sensitive region of the sensor.

Embodiment 10: The readout-circuit according to the preceding embodiment, wherein the readout-circuit is a multi-channel ASIC configured for readout of a plurality of sensors, wherein each sensor is configured for generating the analog sensor current dependent on an illumination of a light-sensitive region of the sensor, wherein the sensors are arranged in an array.

Embodiment 11: The readout-circuit according to any one of the two preceding embodiments, the sensor is at least one sensor configured for generating the analog sensor current dependent on an illumination of its light-sensitive region, wherein the light-sensitive region comprises at least one photoconductive material selected from the group consisting of lead sulfide (PbS); lead selenide (PbSe); mercury cadmium telluride (HgCdTe); cadmium sulfide (CdS); cadmium selenide (CdSe); indium antimonide (InSb); indium arsenide (InAs); indium gallium arsenide (InGaAs); silicon (Si); Silicon Germanium (SiGe); extrinsic semiconductors, organic semiconductors.

Embodiment 12: The readout-circuit according to any one of the preceding embodiments, wherein the IAF circuit comprises

- least one integrator, wherein the integrator comprises at least one operational amplifier and at least one capacitor, wherein an input of the operational amplifier is held to a known voltage $V_{ref}$, wherein the integrator is configured for resetting an output of the operational amplifier to $V_{ref}$ after each saturation event, wherein the integrator is configured for integrating the output of the operational amplifier between the reference voltage $V_{ref}$ and a comparator voltage $V_{comp}$ for determining an integration voltage $V_{int}$;
- at least one comparator, specifically at least one Schmitt-trigger, configured for determining a saturation event;
- at least one counter configured for determining the first digital output count by counting the saturation events; and
- at least one mixed signal circuit configured for resetting $V_{int}$ to $V_{ref}$ after each saturation event.

Embodiment 13: The readout-circuit according to the preceding embodiment, wherein the residual analog sensor current is a leftover analog sensor current after the final IAF cycle that has not triggered a saturation event.

Embodiment 14: A sensor configured for generating an analog sensor current dependent on a sensor reading, wherein the sensor comprises at least one readout-circuit configured for converting the analog sensor current into a digital output count according to any one of the preceding embodiments.

Embodiment 15: The sensor according to the preceding embodiment, wherein the sensor is and/or comprises at least one photodetector comprising at least one sensor configured for generating an analog sensor current dependent on an illumination of a light-sensitive region of the sensor.

Embodiment 16: A method for converting an analog sensor current into a digital output count, wherein the method comprises using at least one readout-circuit according to any one of the preceding embodiments referring to a readout-circuit, the method comprising:

a) converting the analog sensor current into a first digital output count using the IAF-circuit, wherein the interface circuit triggers the IAF-circuit to convert the analog sensor current into the first digital output count upon receiving at least one conversion start signal, wherein the IAF-circuit further triggers a start of the digital counter; and
b) converting a residual analog sensor current after a final IAF cycle into a second digital output count using the residual conversion circuit, wherein the residual conversion circuit determines, by using the system clock, a residual time elapsed between the final IAF cycle and the receiving of at least one conversion end signal, wherein the residual conversion circuit generates the second digital output count based on a ratio of the residual time and a time for one IAF cycle, wherein the determining of the residual time comprises counting predetermined time intervals by using the digital counter and terminating the digital counter by using the interface circuit upon receiving the conversion end signal.

Embodiment 17: The method according to the preceding embodiment, further comprising resetting the digital counter using the IAF-circuit, specifically resetting the digital counter after the termination of the digital counter.

Embodiment 18: The method according to any one of the two preceding embodiments, further comprising determining the time for one IAF cycle based on at least one of a time for the final IAF cycle or an average time of preceding IAF cycles, specifically an average time of all preceding IAF cycles, by using the system clock.

Embodiment 19: The method according to any one of the three preceding embodiments, further comprising:
c) determining a combined digital output count by combining the first digital output count and the second digital output count, wherein the first digital output count is proportional to an integer of IAF cycles.

Embodiment 20: The method according to the preceding embodiment, wherein the combined digital output count is determined according to:

$$ADC_{out} = ADC_{IAF\_Event} + ADC_{residual},$$

wherein $ADC_{out}$ denotes the combined digital output count, $ADC_{IAF\_Event}$ denotes the first digital output count and $ADC_{residual}$ denotes the second digital output count.

Embodiment 21: The method according to any one of the two preceding embodiments, wherein the combined digital output count is determined according to:

$$ADC_{out} = \sum IAF_{Events} + \frac{t_{EndOfMeasurment-LastIAF}}{t_{1IAF}},$$

wherein $\sum IAF_{Events}$ denotes a total number of IAF cycles, $t_{EndOfMeasurment-LastIAF}$ denotes the residual time and $t_{1IAF}$ denotes the time for one IAF cycle.

Embodiment 22: The method according to anyone of the preceding method embodiments, wherein the method is at least partially computer-implemented, specifically at least one of steps b) and c).

Embodiment 23: A computer-readable storage medium, specifically a non-transient computer-readable storage medium, including instructions that, when executed by one or more processors, cause the one or more processors to perform the method according to any one of the preceding embodiments referring to a method.

Embodiment 24: A computer program comprising instructions, which, when executed by one or more processors, cause the one or more processors to perform the method according to any one of the preceding embodiments referring to a method.

Embodiment 25: A use of a readout-circuit according to any one of the preceding embodiments referring to a readout-circuit for readout of one or more of at least one PbS sensor, at least one PbSe sensor, or at least one pixelated sensor array comprising a plurality of pixels, wherein each of the pixels comprises at least one PbS or PbSe sensor.

Short description of the Figures

Further optional features and embodiments will be disclosed in more detail in the subsequent description of embodiments, preferably in conjunction with the dependent claims. Therein, the respective optional features may be realized in an isolated fashion as well as in any arbitrary feasible combination, as the skilled person will realize. The scope of the invention is not restricted by the preferred embodiments. The embodiments are schematically depicted in the Figures. Therein, identical reference numbers in these Figures refer to identical or functionally comparable elements.
In the Figures:

Figure 1      shows an embodiment of a readout-circuit;

Figure 2      shows an exemplary signal diagram;

Figure 3      shows an embodiment of a sensor; and

Figure 4      shows an embodiment of a method for converting an analog sensor current into a digital output count.

Detailed description of the embodiments

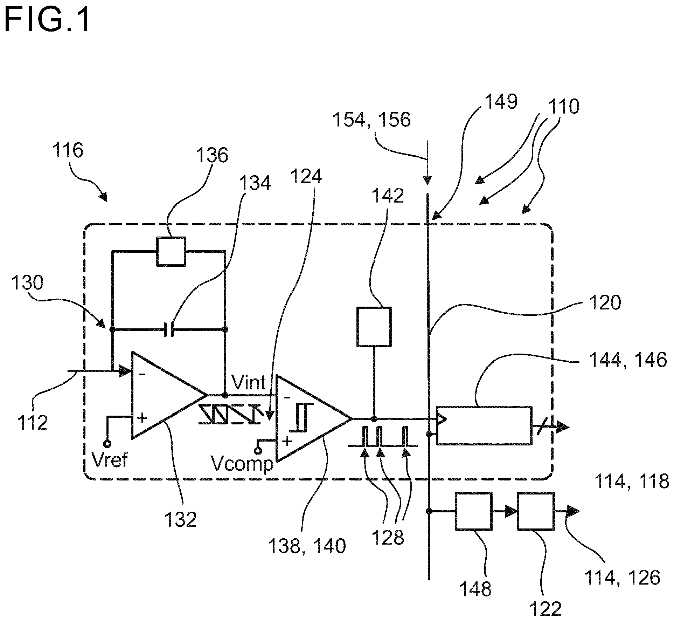

Figure 1 shows an exemplary embodiment of a readout-circuit 110 configured for converting an analog sensor current 112 into a digital output count 114 in a schematic view. The read-out circuit 110 comprises at least one at least one integrate-and-fire (IAF)-circuit 116 configured for converting the analog sensor current 112 into a first digital output count 118, at least one system clock 120 and at least one residual conversion circuit 122 configured for converting a residual analog sensor current 124 after a final IAF cycle into a second digital output count 126.

As shown in Figure 1, the IAF-circuit 116 may be an electric circuit configured for integrating the incoming analog sensor current 112 and firing an event 128, when an output voltage reaches a predefined quantization threshold. The event 128 can be used to reset the integrator 130 in order to start again with the integration of the incoming analog sensor current 112. Different types of IAF-circuits are generally known to the skilled person, e.g. from the publication Dei, Michele, et al., "Highly linear integrate-and-fire modulators with soft reset for low-power high-speed imagers", 2017, IEEE International Symposium on Circuits and Systems (ISCAS), IEEE, which is included here in its entirety. The IAF-circuit 116 may comprise at least one integrator 130. The integrator 130 may be an electric circuit configured for integrating at least one input signal, specifically over time. The integrator 130 may be configured for accumulating the input signal over time. Specifically, the integrator 130 may be a current integrator. The integrator 130 may be configured for measuring the analog sensor current 112. The integrator 130 may comprise at least one of an operational amplifier 132 and a capacitor 134. The operational amplifier 132 may be an inverted operational amplifier. The operational amplifier 132 and the capacitor 134 may be connected in parallel. The IAF-circuit 116 may specifically comprise the at least one capacitor 134, wherein the IAF-circuit 116 may be configured for employing a linear nature of a charge-to-voltage conversion using the capacitor 134. The integrator 130 may comprise at least one mixed signal circuit 136, specifically for resetting the integrator 130. Thus, the IAF-circuit 116 may comprise at least one mixed signal circuit 136 configured for resetting $V_{int}$ after each saturation event 128. The mixed signal circuit 136 may be connected in parallel to the integrator 130 or the capacitor 134 of the integrator 130 generating a short circuit when closed. The mixed signal circuit 136 may be an electrical switch or an electromechanical switch. The mixed signal circuit 136 may comprise at least one transistor such as a field effect transistor or a bipolar junction transistor. Specifically, the mixed signal circuit 136 may comprise at least one transmission gate. The reset of the output of the operational amplifier 132 may be a critical component of the IAF-circuit 116. The IAF-circuit 116 may be configured to ensure that the reset happens quickly and automatically after each saturation event 128. The analog voltage needs to be consistently returned to $V_{ref}$ after every event 128.

An input of the operational amplifier 132 may be held to a known voltage $V_{ref}$. The integrator 130 may be configured for resetting an output of the operational amplifier 132 to $V_{ref}$ after each saturation event 128. The integrator 130 may be configured for integrating the output of the operational amplifier 132 between the reference voltage $V_{ref}$ and a comparator voltage $V_{comp}$ for deter mining an integration voltage $V_{int}$. The output of the operational amplifier 132 $V_{int}$ may be thus $V_{ref} \geq V_{int} \geq V_{comp}$.

The IAF-circuit 116 may further comprise at least one comparator 138 configured for determining a saturation event 128 when $V_{int}$ reaches $V_{comp}$. The comparator 138 may be configured for firing the event 128. The comparator 138 may be an electric circuit configured for comparing at least two input signals, specifically voltages, such as $V_{int}$ and $V_{comp}$. The comparator 138 may be configured for generating at least one output signal, specifically a digital output signal, indicating a result of the comparison, e.g. which input signal is larger. As an example, the comparator 138 may generate as an output "HIGH" or "1" in the case that a first input voltage is higher than a second input voltage and "LOW" or "0" in the case that the first input voltage is lower than the second input voltage. The output signal may be generated continuously over time, specifically for varying input signals. The comparator 138 may be configured for comparing $V_{int}$ with $V_{comp}$. Specifically, the comparator 138 may be configured for detecting when $V_{int}$ is equal to $V_{comp}$. The comparator 138 may be configured for generating an event signal, also denoted as event 128, each time $V_{int}$ crosses $V_{comp}$.

The comparator 138 may be and/or may comprise at least one Schmitt-trigger 140. The Schmitt-trigger 140 may be an inverting or a non-inverting Schmitt-trigger 140. The Schmitt-trigger 140 may be a comparator circuit in which switch-on and switch-off thresholds are offset from each other by a switching hysteresis. The Schmitt-trigger 140 may be configured for comparing an input voltage, specifically a voltage varying over time, with two threshold voltages, an upper threshold voltage and a lower threshold voltage. Specifically, the Schmitt-trigger 140 may be configured for giving out HIGH or 1 in case the input voltage is higher than the upper threshold voltage and LOW or 0 in case the input voltages is lower than the lower threshold voltage, wherein the Schmitt-trigger 140 may further be configured for maintaining a preceding output between the upper threshold voltage and the lower threshold voltage. As long as the input voltage does not exceed one of the two threshold voltage, an output of the Schmitt-trigger 140 may not be altered. However, other options for a comparator 138 are also feasible. The comparator 138 may be connected to an output of the integrator 130, specifically to an output of the operational amplifier 132 of the integrator 130. The comparator 13, specifically an output of the comparator 138, may further be connected to at least one switch control 142. The switch control 142 may be configured for controlling the mixed signal circuit 136 for resetting the integrator 130.

The IAF-circuit 116 may further comprise at least one counter 144 configured for determining the first digital output count 118 by counting the saturation events 128. The counter 144 may be an electric circuit configured for counting the events 128. The counter 144 may be configured for storing a number of times a particular event 128 has occurred. Specifically, for each determined saturation event 128, the counter 144 may be incremented by 1. The counter 144 may comprise at least one output. The counter 144 may be configured for giving out the count. The counter 144 may be configured for giving out the number of times a particular event 128 has occurred, specifically in a binary number system. The counter 144 may comprise a plurality of flip-flops connected in a cascade. The counter 144 may be a synchronous counter or an asynchronous counter. The counter 144 may comprise at least one input. An input of the counter 144 may be connected to the comparator 138. The readout-circuit 110 may comprise a plurality of counters 144. Specifically, the counter 144 of the IAF-circuit 116 may be a MSB counter 146.

The MSB counter 146 may be configured for determining the most significant bits (MSB) of an output of the readout-circuit 110. The MSB counter 146 may be configured for determining the first digital output count 118.

Further, as shown in Figure 1, the readout-circuit 110 further comprises at least one interface circuit 149 for receiving at least one conversion start signal 154 and at least one conversion end signal 156. The interface circuit 149 is configured for triggering the IAF-circuit 116 to convert the analog sensor current 112 into the first digital output count 118 upon receiving the conversion start signal 154. The IAF-circuit 116 is configured for triggering a start of the digital counter 148. The digital counter 148 is configured for being terminated by the interface circuit 149 upon receiving the conversion end signal 156.

The residual conversion circuit 122 is configured, by using the system clock 120, for determining a residual time 162 elapsed between the final IAF cycle and the receiving of the conversion end signal 156, specifically a residual time elapsed since the last IAF cycle. The residual conversion circuit 122 is configured for generating the second digital output count 126 based on a ratio of the residual time 162 and a time for one IAF cycle 160.

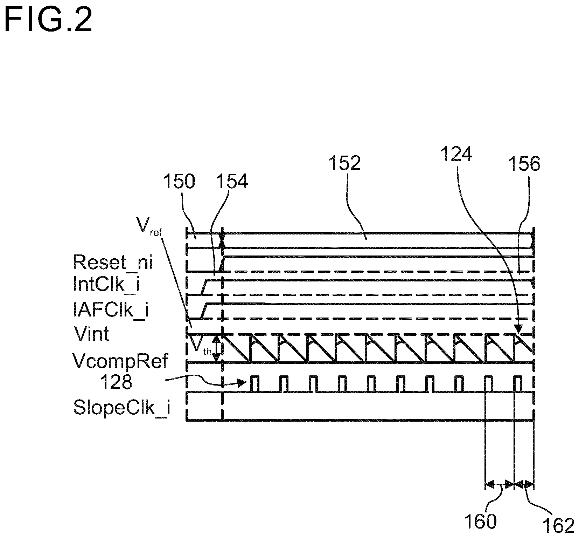

For example, the interface circuit 149 may be configured for receiving an integration clock signal, e.g. from at least one microcontroller (not shown in Figure 1) controlling the read-out circuit 110. The final IAF-cycle may be stopped upon receiving conversion end signal 156, e.g. upon receiving the integration clock signal in a "low" state. The conversion end signal 156 may further stop both the incoming analog sensor current 112 and the digital counter 148. Further, the residual time 162 may be stopped upon receiving conversion end signal 156, e.g. when the integration clock signal goes "low", as exemplarily shown in Figure 2.

Figure 2 shows an exemplary signal diagram during a readout using the readout-circuit 110 as shown in Figure 1. The top row of the diagram indicates a control state of the readout-circuit 110. The read-out circuit 110 may be first in an initialization state 150, followed by an IAF state 152. As indicated in Figure 2, the read-out circuit 110 may count saturation events 128 during the integration measurement each time $V_{int}$ crosses $V_{comp}$. However, after the final IAF cycle, the residual analog sensor current 124 may remain without causing a saturation event. The readout-circuit 110 may be configured, specifically by using the system clock 120, for determining the time for one IAF cycle based on the time for the final IAF cycle (denoted by reference number 160). Alternatively or additionally, an average time of preceding IAF cycles, specifically an average time of all preceding IAF cycles, may be used to determine the time for one IAF cycle. Further, the residual conversion circuit 122 is configured for determining the residual time elapsed between the final IAF cycle and the receiving of the conversion end signal 156 (denoted by reference number 162).

Further, the readout-circuit 110 may be configured for determining a combined digital output count by combining the first digital output count 118 and the second digital output count 126.

The first digital output count 118 may be proportional to an integer of IAF cycles. The readout-circuit 110 may be configured for determining the combined digital output count according to:

$$ADC_{out} = ADC_{IAF\_Event} + ADC_{residual},$$

wherein $ADC_{out}$ denotes the combined digital output count, $ADC_{IAF\_Event}$ denotes the first digital output count 118 and $ADC_{residual}$ denotes the second digital output count 126.

The readout-circuit 110 may be configured for determining the combined digital output count according to:

$$ADC_{out} = \sum IAF_{Events} + \frac{t_{EndOfMeasurement-LastIAF}}{t_{1IAF}},$$

wherein $\Sigma IAF_{Events}$ denotes a total number of IAF cycles, $t_{EndofMeasurment-LastIAF}$ denotes the residual time 162 and $t_{1IAF}$ denotes the time for one IAF cycle 160.

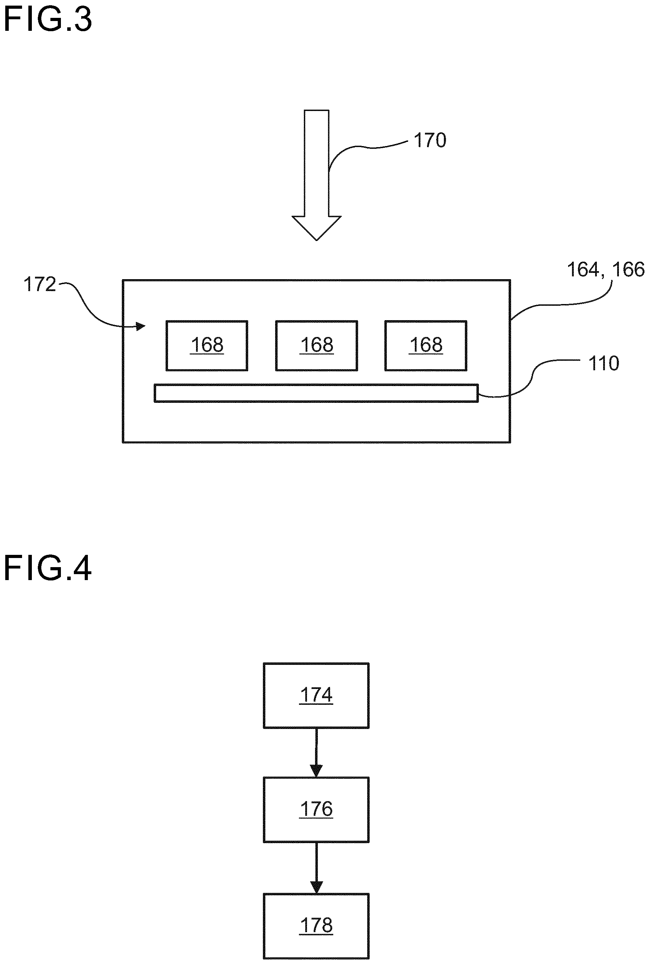

Figure 3 shows an exemplary embodiment of a sensor 164 configured for generating an analog sensor current 112 dependent on a sensor reading in a schematic view. The sensor 164 comprises at least one readout-circuit 110 configured for converting the analog sensor current 112 into a digital output count 114 according to the present invention, such as according to the exemplary embodiment shown in Figure 1 and/or according to any other embodiment disclosed herein. Thus, for a description of the read-out sensor 110, reference is made to the description of Figure 1.

In this example, the sensor 164 may be at least one photodetector 166 comprising at least one sensor 168 configured for generating the analog sensor current 112 dependent on an illumination 170 of a light-sensitive region of the sensor 168. As shown in Figure 3, the sensors 168 may be arranged in an array 172, specifically comprising a plurality of sensors 168. Each sensor 168 may be configured for generating the analog sensor current 112 dependent on an illumination of a light-sensitive region of the sensor 168. The light-sensitive region may comprise at least one photoconductive material selected from the group consisting of lead sulfide (PbS); lead selenide (PbSe); mercury cadmium telluride (HgCdTe); cadmium sulfide (CdS); cadmium selenide (CdSe); indium antimonide (InSb); indium arsenide (InAs); indium gallium arsenide (InGaAs); silicon (Si); Silicon Germanium (SiGe); extrinsic semiconductors, organic semiconductors. In this example, the readout-circuit 110 may be an application-specific integrated circuit (ASIC), specifically a multi-channel ASIC configured for readout of the plurality of sensors.

Figure 4 shows an exemplary embodiment of a method for converting an analog sensor current 112 into a digital output count 114. The method comprises using at least one readout-circuit 110 according to the present invention, such as according to the exemplary embodiment shown in Figure 1 and/or according to any other embodiment disclosed herein. Thus, for a description of the read-out sensor 110, reference is made to the description of Figure 1.

The method may comprise further method steps which are not listed. Further, one or more of the method steps may be performed once or repeatedly. Further, two or more of the method steps may be performed simultaneously or in a timely overlapping fashion.

The method comprises:

a) (denoted by reference number 174) converting the analog sensor current 112 into a first digital output count 118 using the IAF-circuit 116, wherein the interface circuit 149 triggers the IAF-circuit 116 to convert the analog sensor current 112 into the first digital output count 118 upon receiving at least one conversion start signal 154, wherein the IAF-circuit 116 further triggers a start of the digital counter 148; and

b) (denoted by reference number 176) converting a residual analog sensor current 124 after a final IAF cycle into a second digital output count 126 using the residual conversion circuit 122, wherein the residual conversion circuit 122 determines, by using the system clock 120, a residual time 162 elapsed between the final IAF cycle and the receiving of at least one conversion end signal 156, wherein the residual conversion circuit 122 generates the second digital output count 126 based on a ratio of the residual time 162 and a time for one IAF cycle 160, wherein the determining of the residual time 162 comprises counting predetermined time intervals by using the digital counter 148 and terminating the digital counter 148 by using the interface circuit 149 upon receiving the conversion end signal 156.

The method may comprise, specifically in and/or after step b), resetting the digital counter 148 using the IAF-circuit 116, specifically resetting the digital counter 148 after the termination of the digital counter 148.

The method may further comprise determining the time for one IAF cycle 160 based on at least one of a time for the final IAF cycle or an average time of preceding IAF cycles, specifically an average time of all preceding IAF cycles, by using the system clock 120.

The method may further comprise:

c) (denoted by reference number 178) determining a combined digital output count by combining the first digital output count 118 and the second digital output count 126, wherein the first digital output count 118 is proportional to an integer of IAF cycles.

The combined digital output count may be determined according to:

$$ADC_{out} = ADC_{IAF\_Event} + ADC_{residual},$$

wherein $ADC_{out}$ denotes the combined digital output count, $ADC_{IAF\_Event}$ denotes the first digital output count 118 and $ADC_{residual}$ denotes the second digital output count 126.

Alternatively or additionally, the combined digital output count may be determined according to:

$$ADC_{out} = \sum IAF_{Events} + \frac{t_{EndOfMeasurment-LastIAF}}{t_{1IAF}},$$

wherein $\Sigma IAF_{Events}$ denotes a total number of IAF cycles, $t_{EndofMeasurment\text{-}LastIAF}$ denotes the residual time 162 and $t_{1IAF}$ denotes the time for one IAF cycle 160.

List of reference numbers

**[0092]**

| | |
|---|---|
| 110 | readout-circuit |
| 112 | analog sensor current |
| 114 | digital output count |
| 116 | IAF-circuit |
| 118 | first digital output count |
| 120 | system clock |
| 122 | residual conversion circuit |
| 124 | residual analog sensor current |
| 126 | second digital output count |
| 128 | event |
| 130 | integrator |
| 132 | operational amplifier |
| 134 | capacitor |
| 136 | mixed signal circuit |
| 138 | comparator |
| 140 | Schmitt-trigger |
| 142 | switch control |
| 144 | counter |
| 146 | MSB counter |
| 148 | digital counter |
| 149 | interface circuit |
| 150 | initialization state |
| 152 | IAF state |
| 154 | conversion start signal |
| 156 | conversion end signal |
| 160 | time for one IAF cycle |
| 162 | residual time |
| 164 | sensor |
| 166 | photodetector |
| 168 | sensor |
| 170 | illumination |
| 172 | array |
| 174 | converting the analog sensor current into a first digital output count |
| 176 | converting a residual analog sensor current into a second digital output count |
| 178 | determining a combined digital output count |

**Claims**

**1.** A readout-circuit (110) configured for converting an analog sensor current (112) into a digital output count (114), comprising

- at least one integrate-and-fire (IAF)-circuit (116) configured for converting the analog sensor current (112) into a first digital output count (118);
- at least one system clock (120), the system clock (120) comprising at least one digital counter (148) configured for counting predetermined time intervals;
- at least one interface circuit (149) for receiving at least one conversion start signal (154) and at least one conversion end signal (156), wherein the interface circuit (149) is configured for triggering the IAF-circuit to convert the analog sensor current into the first digital output count upon receiving the conversion start signal (154), wherein the IAF-circuit (116) is configured for triggering a start of the digital counter (148), wherein the digital counter (148) is configured for being terminated by the interface circuit (149) upon receiving the conversion end signal (156); and

- at least one residual conversion circuit (122) configured for converting a residual analog sensor current (124) after a final IAF cycle into a second digital output count (126), wherein the residual conversion circuit (122) is configured, by using the system clock (120), for determining a residual time (162) elapsed between the final IAF cycle and the receiving of the conversion end signal (156), wherein the residual conversion circuit (122) is configured for generating the second digital output count (126) based on a ratio of the residual time (162) and a time for one IAF cycle (160).

2. The readout-circuit (110) according to the preceding claim, wherein the IAF-circuit (116) is configured for resetting the digital counter (148).

3. The readout-circuit (110) according to any one of the preceding claims, wherein the readout-circuit (110) is configured for determining the time for one IAF cycle (160) based on at least one of a time for the final IAF cycle or an average time of preceding IAF cycles.

4. The readout-circuit (110) according to any one of the preceding claims, wherein the readout-circuit (110) is configured for determining a combined digital output count by combining the first digital output count (118) and the second digital output count (126), wherein the first digital output count (118) is proportional to an integer of IAF cycles, wherein the readout-circuit (110) is configured for determining the combined digital output count according to:

$$ADC_{out} = \sum IAF_{Events} + \frac{t_{EndOfMeasurement-LastIAF}}{t_{1IAF}},$$

wherein $\Sigma IAF_{Events}$ denotes a total number of IAF cycles, $t_{EndOfMeasurment-LastIAF}$ denotes the residual time (162) and $t_{1IAF}$ denotes the time for one IAF cycle (160).

5. The readout-circuit (110) according to any one of the preceding claims, wherein the system clock (120) is a 8 MHz system clock.

6. The readout-circuit (110) according to any one of the preceding claims, wherein the system clock (120) is a resistor-capacitor (RC) clock oscillator, a quartz oscillator or a Bulk-Acoustic-Wave (BAW) oscillator.

7. The readout-circuit (110) according to any one of the preceding claims, wherein the readout-circuit (110) is an application-specific integrated circuit (ASIC) configured for readout of at least one sensor (164).

8. The readout-circuit (110) according to any one of the preceding claims, wherein the IAF circuit (116) comprises

- least one integrator (130), wherein the integrator (130) comprises at least one operational amplifier (132) and at least one capacitor (134), wherein an input of the operational amplifier (132) is held to a known voltage $V_{ref}$, wherein the integrator (130) is configured for resetting an output of the operational amplifier (132) to $V_{ref}$ after each saturation event (128), wherein the integrator (130) is configured for integrating the output of the operational amplifier (132) between the reference voltage $V_{ref}$ and a comparator voltage $V_{comp}$ for determining an integration voltage $V_{int}$;
- at least one comparator (138) configured for determining a saturation event (128);
- at least one counter (14) configured for determining the first digital output count (118) by counting the saturation events (128); and
- at least one mixed signal circuit (136) configured for resetting $V_{int}$ to $V_{ref}$ after each saturation event (128).

9. A sensor (164) configured for generating an analog sensor current (112) dependent on a sensor reading, wherein the sensor (164) comprises at least one readout-circuit (110) configured for converting the analog sensor current (112) into a digital output count (114) according to any one of the preceding claims.

10. A method for converting an analog sensor current (112) into a digital output count (114), wherein the method comprises using at least one readout-circuit (110) according to any one of the preceding claims referring to a readout-circuit (110), the method comprising:

a) converting the analog sensor current (112) into a first digital output count (118) using the IAF-circuit (116), wherein the interface circuit (149) triggers the IAF-circuit to convert the analog sensor current into the first digital output count upon receiving at least one conversion start signal (154), wherein the IAF-circuit (116) further triggers a start of the digital counter (148); and

b) converting a residual analog sensor current (124) after a final IAF cycle into a second digital output count (126) using the residual conversion circuit (122), wherein the residual conversion circuit (122) determines, by using the system clock, a residual time (162) elapsed between the final IAF cycle and the receiving of at least one conversion end signal (156), wherein the residual conversion circuit (122) generates the second digital output count (126) based on a ratio of the residual time (162) and a time for one IAF cycle (160), wherein the determining of the residual time (162) comprises counting predetermined time intervals by using the digital counter (148) and terminating the digital counter (148) by using the interface circuit (149) upon receiving the conversion end signal (156).

11. The method according to the preceding claim, further comprising resetting the digital counter (148) using the IAF-circuit (116).

12. The method according to any one of the two preceding claims, further comprising determining the time for one IAF cycle (160) based on at least one of a time for the final IAF cycle or an average time of preceding IAF cycles.

13. The method according to any one of the three preceding claims, further comprising:

c) determining a combined digital output count by combining the first digital output count (118) and the second digital output count (126), wherein the first digital output count (118) is proportional to an integer of IAF cycles, wherein the combined digital output count is determined according to:

$$ADC_{out} = \sum IAF_{Events} + \frac{t_{EndOfMeasurment-LastIAF}}{t_{1IAF}},$$

wherein $\Sigma IAF_{Events}$ denotes a total number of IAF cycles, $t_{EndOfMeasurment-LastIAF}$ denotes the residual time (162) and $t_{1IAF}$ denotes the time for one IAF cycle (160).

14. A computer program comprising instructions, which, when executed by one or more processors, cause the one or more processors to perform the method according to any one of the preceding claims referring to a method.

15. A use of a readout-circuit (110) according to any one of the preceding claims referring to a readout-circuit (110) for readout of one or more of at least one PbS sensor, at least one PbSe sensor, or at least one pixelated sensor array comprising a plurality of pixels, wherein each of the pixels comprises at least one PbS or PbSe sensor.

## FIG.1

# FIG.2

# FIG.3

170

172

164, 166

| | 168 | | 168 | | 168 | |

110

# FIG.4

174

176

178

Europäisches
Patentamt

European
Patent Office

Office européen
des brevets

## EUROPEAN SEARCH REPORT

Application Number

EP 23 18 0022

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 11 047 733 B2 (AMS INT AG [CH]) 29 June 2021 (2021-06-29) * column 5, lines 30-33; figures 1,2 * * column 8, lines 51-52 * * column 9, line 65 - column 10, line 20 * ----- | 1-15 | INV. H03M1/50 G01J1/46 |
| X | US 10 447 293 B1 (HAIRSTON ALLEN W [US]) 15 October 2019 (2019-10-15) * abstract; figures 1,2 * ----- | 1,10,14 | |

TECHNICAL FIELDS
SEARCHED (IPC)

H03M
G01J

The present search report has been drawn up for all claims

| Place of search | Date of completion of the search | Examiner |
|---|---|---|
| The Hague | 28 November 2023 | Galardi, Leonardo |

EPO FORM 1503 03.82 (P04C01)

**ANNEX TO THE EUROPEAN SEARCH REPORT
ON EUROPEAN PATENT APPLICATION NO.**

**EP 23 18 0022**

This annex lists the patent family members relating to the patent documents cited in the above-mentioned European search report.
The members are as contained in the European Patent Office EDP file on
The European Patent Office is in no way liable for these particulars which are merely given for the purpose of information.

**28-11-2023**

| Patent document cited in search report | | Publication date | Patent family member(s) | | Publication date |
|---|---|---|---|---|---|
| US 11047733 | B2 | 29-06-2021 | CN | 110366823 A | 22-10-2019 |
| | | | EP | 3370340 A1 | 05-09-2018 |
| | | | US | 2020003616 A1 | 02-01-2020 |
| | | | WO | 2018158384 A1 | 07-09-2018 |
| US 10447293 | B1 | 15-10-2019 | NONE | | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A. NASCETTI**. Fractional charge packet counting with constant relative resolution. *International Journal of Circuit Theory and Applications, Int. J. Circ. Theor. Appl.*, 2012, vol. 40, 175-187

- Highly linear integrate-and-fire modulators with soft reset for low-power high-speed imagers. **DEI, MICHELE et al.** 2017 IEEE International Symposium on Circuits and Systems (ISCAS). IEEE, 2017